# EUROPEAN PATENT APPLICATION

(11) **EP 1 986 471 A1**
(43) Date of publication of application: **29.10.2008**
(21) Application number: 07714103.4
(22) Date of filing: 13.02.2007
(51) Int. Cl.: H05B 33/10, H01L 51/50, H05B 33/26

(54) **LIGHT-EMITTING DEVICE, METHOD FOR MANUFACTURING LIGHT-EMITTING DEVICE, AND SUBSTRATE PROCESSING APPARATUS**

(30) Priority: 14.02.2006 JP 2006036917
(71) Applicant: Tokyo Electron Limited, Tokyo 107-6325 (JP); National University Corporation Tohoku Unversity, Sendai-shi, Miyagi 980-8577 (JP)
(72) Inventor: NOZAWA, Toshihisa, Amagasaki-Shi, Hyogo 660-0891 (JP); MOYAMA, Kazuki, Amagasaki-Shi, Hyogo 660-0891 (JP); OHMI, Tadahiro, Sendai-Shi, Miyagi 980-8577 (JP); KAWAMURA, Chuichi, Kariya-Shi, Aichi 448-8671 (JP); YOSHINO, Kimihiko, Kariya-Shi, Aichi 448-8671 (JP)
(74) Representative: HOFFMANN EITLE
(86) International application number: PCT/JP2007/052521
(87) International publication number: WO 2007/094322

(57) **Abstract**

A substrate process apparatus that forms a light emitting device configured with an organic layer including a light emitting layer on a substrate to be processed, the organic layer being formed between a first electrode and a second electrode, includes an organic layer forming apparatus wherein the organic layer is formed on the first electrode formed on the substrate to be processed; an electrode forming apparatus wherein the second electrode is formed on the organic layer; and an etching apparatus wherein the organic layer is etched.

## Description

### TECHNICAL FIELD

The present invention relates to a light emitting device configured with an organic light emitting formed layer between two electrodes and a substrate process apparatus for forming the light emitting device.

### BACKGROUND ART

In recent years, a planar display apparatus that may be made into a thin model has been developed toward a practical application, as a replacement of a cathode ray tube (CRT) that has been long used. For example, an organic electroluminescent device (organic EL device) has drawn attention as a next generation display apparatus because of advantages of self-luminous capability, a high-speed response, and the like. The organic EL device may be used as a planar light emitting device in addition to the display apparatus.

The organic EL device is configured with an organic layer including an organic EL layer (light emitting layer) sandwiched by a positive electrode and a negative electrode. A hole is injected from the positive electrode into the light emitting layer and an electron is injected from the negative electrode into the light emitting layer, where the hole and the electron are recombined, thereby emitting light from the light emitting layer.

In addition, a hole transport layer may be added between the positive electrode and the light emitting layer in the organic layer, or an electron transport layer may be provided between the negative electrode and the light emitting layer in the organic layer, in order to improve light emitting efficiency, if required.

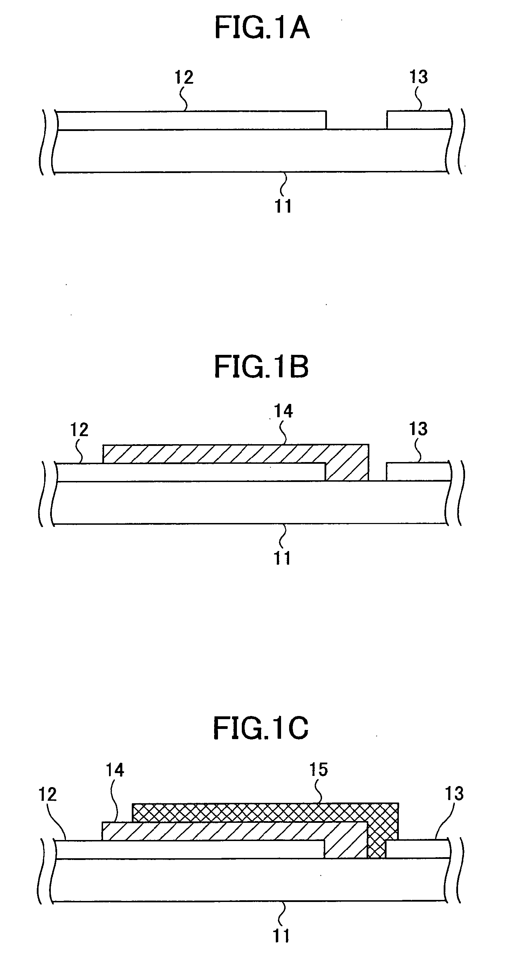

For example, FIGS. 1A through 1D sequentially illustrate an example of a method of forming the above light emitting device.

First, a substrate 11, on which a positive electrode 12 and a leading wire 13 for a negative electrode to be formed in a subsequent step are formed, is prepared in a process shown in FIG. 1A. On the substrate 11, an active matrix drive circuit such as a thin film transistor (TFT) connected to, for example, the positive electrode 12 may be formed.

Next, an organic layer 14 including the light emitting layer (the organic EL layer) is formed by an evaporation method on the positive electrode 12 in a process shown in FIG. 1B. In this case, the organic layer 14 is preferably formed not on an entire surface of the substrate 11 but into a predetermined pattern so that the leading wire 13 is exposed. Patterning the evaporated film is carried out by a so-called mask evaporation method that is carried out with, for example, a patterned mask (not shown) attached on the substrate, which has been widely employed.

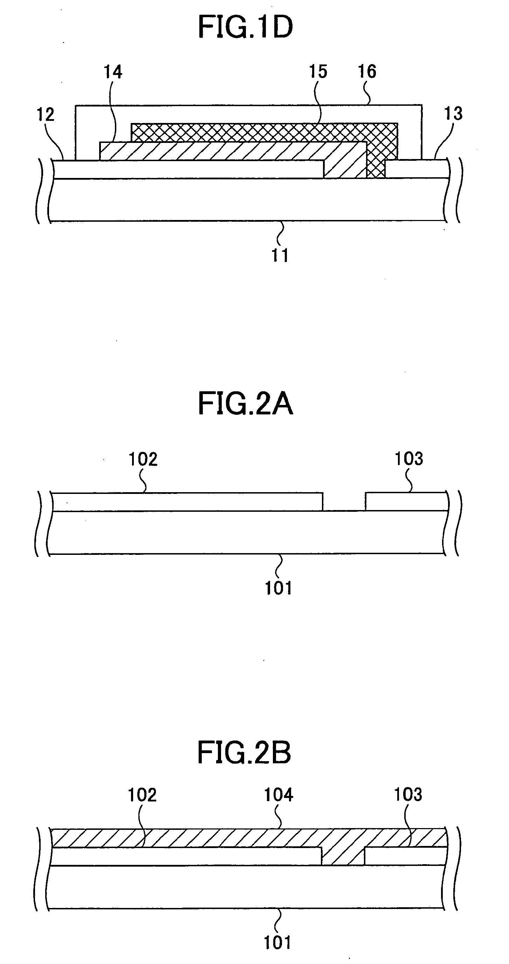

Next, a negative electrode 15 is formed on the organic layer 14 by, for example, a sputtering method in a process shown in FIG. 1C. Then, a protection layer (insulation layer) 16 is formed in order to cover the organic layer 14 in a process shown in FIG. 1D, thereby forming a light emitting device.

However, the substrate 11 and the mask (stencil mask) may be raised to high temperatures when the organic layer is formed by evaporation. Therefore, the mask attached on the substrate may be deformed, which degrades patterning accuracy of the mask evaporation, leading to reduced quality of the light emitting device.

In addition, deformation of the mask caused by heat and attaching/removing the mask may cause particles, which may lead to degraded quality and reduced production yield of the light emitting device.

Patent-related Document 1: Japanese Patent Application Laid-Open Publication No. 2004-225058.

### DISCLOSURE OF THE INVENTION

### PROBLEMS TO BE SOLVED BY THE INVENTION

The present invention is generally directed to a novel and useful fabrication method of a light emitting device and a substrate process apparatus for fabricating the light emitting device, which are capable of solving the above-mentioned problems.

The present invention is specifically directed to a high quality light emitting device, a fabrication method of the light emitting device, and a substrate process apparatus capable of fabricating the light emitting device.

### MEANS OF SOLVING THE PROBLEMS

According to a first aspect of the present invention, the above problems are solved by a fabrication method of a light emitting device configured with an organic layer including a light emitting layer, the organic layer being formed between a first electrode and a second electrode. The method includes an organic layer forming step wherein the organic layer is formed on the first electrode formed on a substrate; an electrode forming step wherein the second electrode is formed on the organic layer; and an etching step wherein the organic layer is etched.

According to a second aspect of the present invention, the above problems are solved by a substrate process apparatus wherein a light emitting device configured with an organic layer including a light emitting layer, the organic layer being formed between a first electrode and a second electrode, is formed on a substrate to be processed. The substrate process apparatus includes an organic layer forming apparatus wherein the organic layer is formed on the first electrode formed on the substrate to be processed; an electrode forming apparatus wherein the second electrode is formed on the organic layer; and an etching apparatus wherein the organic layer is etched.

According to a third aspect of the present invention, the above problems are solved by a light emitting device configured with an organic layer including a light emitting layer, the organic layer being formed between a first electrode and a second electrode. The light emitting device includes the second electrode and the organic layer that are patterned to have substantially the same top view shape.

### EFFECTS OF THE INVENTION

According to an example of the present invention, a high quality light emitting device, a fabrication method of the light emitting device, and a substrate process apparatus capable of fabricating the light emitting device may be provided.

### BRIEF DESCRIPTION OF THE DRAWING

FIG. 1A illustrates a related art fabrication method of a light emitting device (Part 1).
FIG. 1B illustrates the related art fabrication method of the light emitting device (Part 2).
FIG. 1C illustrates the related art fabrication method of the light emitting device (Part 3).
FIG. 1D illustrates the related art fabrication method of the light emitting device (Part 4).
FIG. 2A illustrates a fabrication method according to a first example for fabricating a light emitting device (Part 1).
FIG. 2B illustrates the fabrication method according to the first example for fabricating the light emitting device (Part 2).
FIG. 2C illustrates the fabrication method according to the first example for fabricating the light emitting device (Part 3).
FIG. 2D illustrates the fabrication method according to the first example for fabricating the light emitting device (Part 4).
FIG. 2E illustrates the fabrication method according to the first example for fabricating the light emitting device (Part 5).
FIG. 2F illustrates the fabrication method according to the first example for fabricating the light emitting device (Part 6).
FIG. 3A illustrates a fabrication method according to a second example for fabricating a light emitting device (Part 1).
FIG. 3B illustrates the fabrication method according to the second example for fabricating the light emitting device (Part 2).
FIG. 3C illustrates the fabrication method according to the second example for fabricating the light emitting device (Part 3).
FIG. 3D illustrates the fabrication method according to the second example for fabricating the light emitting device (Part 4).
FIG. 3E illustrates the fabrication method according to the second example for fabricating the light emitting device (Part 5).
FIG. 3F illustrates the fabrication method according to the second example for fabricating the light emitting device (Part 6).
FIG. 3G illustrates the fabrication method according to the second example for fabricating the light emitting device (Part 7).
FIG. 4 illustrates a substrate process apparatus according to a third example.
FIG. 5 is a modification example of the substrate process apparatus of FIG. 4.
FIG. 6 illustrates a substrate process apparatus according to a fourth example.
FIG. 7 is a modification example of the substrate process apparatus of FIG. 6.
FIG. 8 is an example of an organic layer forming apparatus for use in the substrate process apparatus of FIG. 4.
FIG. 9 is an example of an electrode forming apparatus for use in the substrate process apparatus of FIG.
4.

FIG. 10 is an example of an etching apparatus for use in the substrate process apparatus of FIG. 4.

### DESCRIPTION OF THE REFERENCE NUMERALS

100, 200: light emitting device
101, 201: substrate
102, 202: positive electrode
103, 203: leading wire
104, 204: organic layer
105, 205: negative electrode
106, 206, 206a: protection film
TC1, TC2, TC3, TC4, TC5, TC6, TC7, TC8, TC9, TC10, tc1, tc2, tc3, tc4, tc5, tc6, tc7, tc8, tc9, tc10, tc11, tc12, tc13, tc14: transfer chamber
TA1, TA2, TA3, TA4, TA5, TA6, TA7, TA8, TA9, TA10, ta1, ta2, ta3, ta4, ta5, ta6, ta7, ta8, ta9, ta10, ta11, ta12, ta13, ta14: transfer unit
AL1, AL2, AL3, AL4, AL5, AL6, AL7, all, al2, al3, al4, al5, al6, al7, al8, al9, al10, al11, al12: alignment processing chamber
CL1, cl1: pretreatment chamber
LL1, LL2, LL3, LL4, ll1, ll2, ll3, ll4: load lock chamber
VA1, VA2, VA3, va1, va2, va3: deposition apparatus
SP1, SP2, SP3, SP4, sp1, sp2, sp3, sp4, sp5, sp6, sp7, sp8: deposition apparatus
CV1, CV2, CV3, CV4, cv1, cv2, cv3, cv4, cv5, cv6, cv7, cv8: deposition apparatus
ET1, ET2, ET3, ET4, et1, et2, et3, et4: etching apparatus
300A: inner space
301: process vessel
302: evaporation source
302A: source material
303: heater
304: evacuation line
305: substrate holding pedestal
306: transfer rail
307: gate valve
400A: inner space
401: process vessel
402: substrate holding pedestal
403: target
404: radio frequency source
406: evacuation line
407: gas supplying portion
501, 502: process vessel
503: coil
504, 510: radio frequency source
506: ground plate
507: gate valve
508: gas supplying portion
509: evacuation line

### BEST MODE OF CARRYING OUT THE INVENTION

Referring to the accompanying drawings, preferred embodiments according to the present invention will be described in the following.

### < Example 1 >

A fabrication method of a light emitting device according to this example is to fabricate a light emitting device configured with an organic layer including a light emitting layer formed between a first electrode (positive electrode) and a second electrode (negative electrode). The fabrication method includes an organic layer forming step where the organic layer is formed on the first electrode formed on a substrate, an electrode forming step where the second electrode is formed on the organic layer, and an etching step where the organic layer is etched.

Namely, this example is characterized in that the organic layer is patterned by etching rather than a mask evaporation method. One example of the fabrication method of the light emitting device is sequentially described referring to FIGS. 2A through 2F. In the drawings, the same reference marks are given to the portions described above, and explanation may be omitted.

First, a so-called electrode provided substrate is prepared in a step shown in FIG. 2A. In the substrate, a positive electrode 102 formed of a transparent material such as ITO and a leading wire 103 for the negative electrode to be formed in the subsequent step are formed on a transparent substrate 101 composed of, for example, glass or the like. In this case, the positive electrode 102 (the leading wire 103) is formed by a sputtering method.

In addition, the substrate 101 may include a control device such as a TFT, which controls emission from the light emitting device. For example, when the light emitting device formed according to this example is used in a display apparatus, a device for control such as the TFT may be incorporated, for example, for every pixel.

In this case, a source electrode of the TFT is connected to the positive electrode 102, and a gate electrode and a drain electrode of the TFT are connected to a gate line and a drain line that are formed into a grid, respectively, thereby controlling every pixel to create an image. In this case, the leading wire 103 is connected to a predetermined control circuit (not shown). Such a drive circuit of the display apparatus is called an active matrix drive circuit. In the drawing, such an active matrix drive circuit is omitted.

Next, an organic layer 104 including a light emitting layer (organic EL layer) is formed on the positive electrode 102, the leading wire 103, and the substrate 101 by the evaporation method so that the organic layer 104 covers the positive electrode 102, the leading wire 103, and exposed portions of the substrate 101 in a step shown in FIG. 2B. In this case, the evaporation method is carried out without any mask, so that the organic layer 104 is formed over substantially the entire surface of the substrate 101.

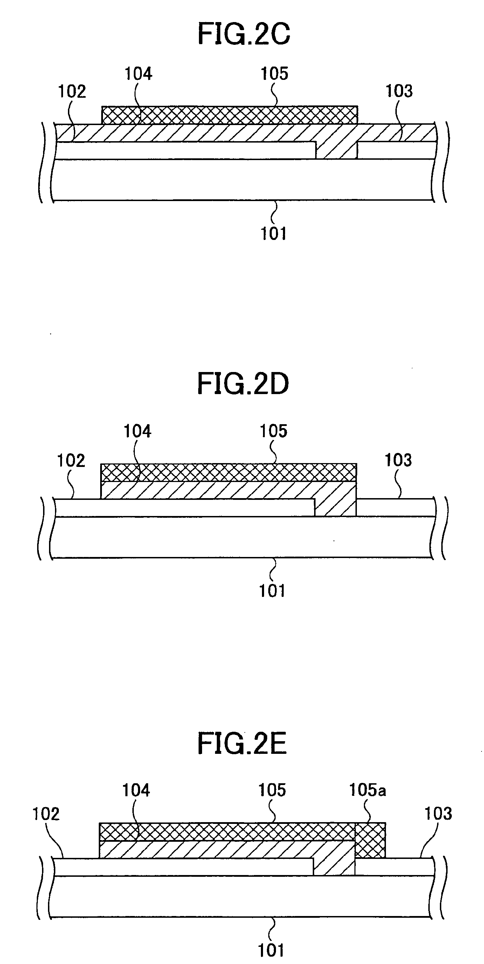

Next, a negative electrode 105 formed of, for example, Ag is formed into a predetermined pattern on the organic layer 104 by a sputtering method using, for example, a patterned mask, in a step shown in FIG. 2C. However, the negative electrode 105 may be patterned by an etching method accompanying a photolithography method after the negative electrode 105 is blanketly formed.

Next, the organic layer 104 is patterned by, for example, plasma-etching the organic layer 104 using as a mask the negative electrode 105 that has been patterned in the step shown in FIG. 2C, in a step shown in FIG. 2D. In this step, the organic layer 104 is removed by etching in an area where the organic layer 104 needs to be removed (e.g., an area above the leading wire 103, and another area that does not need the light emitting layer), so that the organic layer 104 is patterned.

Next, a connection line 105a that is to electrically connect the negative electrode 105 to the leading wire 103 is formed into a pattern by a sputtering method using, for example, a patterning mask in a step shown in FIG. 2E.

Next, a protection film 106 formed of, for example, silicon nitride (SiN) is formed on the substrate 101 by a CVD method using a patterning mask, so that the protection film 106 covers part of the positive electrode 102, part of the leading wire 103, the organic layer 104, the negative electrode 105, and the connection line 105a.

In such a manner, a light emitting device 100 configured with the organic layer 104 formed between the positive electrode 102 and the negative electrode 105 can be formed on the substrate 101. The light emitting device 100 may also be called an organic EL device.

The light emitting device 100 is configured so that holes and electrons are injected to the light emitting layer included in the organic layer 104 from the positive electrode 102 and the negative electrodes 105, respectively, by applying voltage across the positive electrode 102 and the negative electrode 105, and then the holes and the electrons are recombined, thereby emitting light.

The light emitting layer may be formed of a material such as a polycyclic aromatic hydrocarbon, a hetero-aromatic compound, an organic metal complex compound, and the like, all of which may be formed by the evaporation method.

In order to improve light emitting efficiency in the light emitting layer, a hole transport layer, a hole injection layer, and the like may be formed between the positive electrode 102 and the light emitting layer in the organic layer 104. However, both or either one of the hole transport layer and the hole injection layer may be omitted.

Similarly, an electron transport layer, an electron injection layer, and the like may be formed between the negative electrode 105 and the light emitting layer in the organic layer 104 in order to improve light emitting efficiency in the light emitting layer. However, both or either one of the electron transport layer and the electron injection layer may be omitted.

Moreover, a layer doped with a substance such as Li, LiF, CsCO₃, and the like may be formed at a boundary between the organic layer 104 and the negative electrode 105 in order to adjust work function at the boundary (or in order to improve the light emitting efficiency).

For example, the light emitting layer may be formed of, for example, aluminum-quinolinol complex (Alq3) as a host material and rubrene as a dopant. However, the light emitting layer may be formed of various other materials without being limited to the above.

For example, the positive electrode 102 may have the thickness of 100 µm through 200 µm; the organic layer 104 may have the thickness of 50 µm through 200 µm; and the negative electrode 105 may have the thickness of 50 µm through 300 µm.

Additionally, the light emitting device 100 may be applied to, for example, the display apparatus (organic EL display apparatus) and a planar light emitting device (an illumination lamp, a light source, and the like). However, the light emitting device 100 may be used in various electronic appliances without being limited to the above.

When the fabrication method of the light emitting device described above according to this example is employed, the mask evaporation method, which has been conventionally used, is not required to form the organic layer 104. Therefore, various problems caused by the mask evaporation method can be avoided. For example, a problem of reduced patterning accuracy of the evaporation film (the organic layer 104), which is caused by deformation of the mask whose temperature is raised during the evaporation, can be avoided.

Such a problem may be significant and serious, particularly in the evaporation process where a deposition temperature can be higher, compared to the sputtering process where the deposition temperature is relatively lower. In the fabrication method of the light emitting device according to this example, the problem of the reduced patterning accuracy can be avoided, and thus the patterning accuracy is improved, thereby providing a high quality light emitting device.

Moreover, when the mask is deformed and when the mask is attached/removed in the conventional mask evaporation method, particles may be generated, which lead to degraded quality and reduced fabrication yield of the light emitting device. When the fabrication method according to this example is employed, particles caused by the mask evaporation can be prevented from being generated, and thus the high quality light emitting device can be fabricated with improved fabrication yield.

In addition, because the organic layer 104 is etched with the negative electrode 105 used as the mask in the fabrication method according to this example, the mask patterning process such as a photolithography method necessary for, for example, the conventional plasma-etching is not required, which is preferable in that a fabrication process is simplified.

Moreover, when the protection film 106 is formed by the plasma CVD method, damage on the organic layer 104 when forming the protection film 106 is suppressed because the organic layer 104 is covered with the negative electrode 105, which is advantageous for prolonged life of the light emitting device.

In addition, because the organic layer 104 is etched with the negative electrode 105 as the mask, the organic layer 104 between adjacent negative electrodes 105 is removed. However, because light emission for creating an image is caused in a region sandwiched by the negative electrode 105 and the positive electrode 102, there are no problems in creating an image, thereby providing an image quality comparable with that in a usual display apparatus. Namely, the etching with the negative electrode 105 as the mask is an advantageous technique in that the organic layer 104 (light emitting layer) for creating an image (emission) is assuredly obtained (masked) and protected, and the fabrication method can be simplified.

Moreover, because the negative electrode 105 and the organic layer 104 are patterned substantially in the same shape when seen from above in the light emitting device 100, a light emitting area can be substantially enlarged, compared to conventional light emitting devices, as described in the following.

For example, because the negative electrode 15 is patterned after the organic layer 14 is formed by the mask evaporation method in the conventional light emitting device shown in FIG. 1D, a process margin for ensuring insulation between the positive electrode and the negative electrode needs to be retained. Therefore, the organic layer 14 needs to be larger than the negative electrode 15, which causes a problem in that the light emitting area is substantial reduced.

On the other hand, because the organic layer 104 is patterned with the negative electrode 105 as the mask after the negative electrode 105 is patterned, the organic layer 104 is patterned into substantially the same shape (area) as the negative electrode 105 when seen from above. Therefore, there are almost no regions of the organic layer 104 that are not sandwiched by the negative electrode 105 and the positive electrode 104, and retained for the insulation margin, which makes the light emitting device 100 according to this example more advantageous than the conventional light emitting device in terms of larger areas of the patterned organic layer 104 that contribute to light emission.

As a gas plasma-excited for plasma-etching the organic layer 104 (referred to as a process gas below), oxygen (O₂), hydrogen (H₂), and the like may be used However, when the negative electrode 105 is formed of Ag as a primary constituent, oxygen or hydrogen is preferably avoided in the process gas.

When oxygen or hydrogen is used as the process gas, for example, Ag constituting the negative electrode 105 is exposed to active oxygen or hydrogen excited by plasma. As a result, the negative electrode 105 may be eroded or peeled off from the organic layer 104. Therefore, the negative electrode 105 may be formed of, for example, aluminum having higher erosion tolerance as a primary constituent.

In order to suppress the erosion in the negative electrode 105 or influence from the etching the negative electrode 105, the negative electrode 105 may be protected by nitriding a surface of the negative electrode 105 (or providing a protection film formed of a nitride film on the surface).

On the other hand, in the case of a so-called bottom emission type light emitting device such as the light emitting device 100, the negative electrode 105 is used as a light reflection layer that reflects emission from the organic layer 104 (light emitting layer). Therefore, the negative electrode 105 preferably has a high reflectivity with respect to visible light and is preferably formed of, for example, Ag having a high reflectivity with respect to visible light as a primary constituent. In this case, a material having Ag as a primary constituent may include Ag purified to such a high degree that the reflectivity is not practically reduced, and also substantially pure Ag.

When the negative electrode 105 is formed of a material having Ag as a primary constituent, nitrogen (N₂) is preferably used as the process gas. For example, nitrogen gives less influence to metal such as Ag in terms of erosion, compared to oxygen and hydrogen, and can efficiently etch the organic layer 104. The organic layer 104 including, for example, C and H, is thought to be removed by plasma-etching as expressed by the following reaction.

CₓH_{y} + N*_{z} → HCN ↑ (N* represents a nitrogen radical)

Therefore, when N₂ is used as the process gas, the organic layer 104 can be efficiently etched with the mask of the negative electrode 105 formed of Ag as a primary constituent, while damage caused on the negative electrode 105 is suppressed.

In addition, when N₂ is used as the process gas, a noble gas (e.g., He, Ar, Xe, and the like) is preferably added to the process gas. In this case, because the noble gas contributes to nitrogen dissociation by plasma, nitrogen dissociation can be facilitated, thereby providing an enhanced etching efficiency. Moreover, when the noble gas is added to the process gas, it has been found by the inventors of the present invention that the etching efficiency (etching rate) differs depending on a kind of noble gas. For example, when a mixture of nitrogen and the noble gas (e.g., any one of He, Ar, Xe) is used as the process gas, the etching rate becomes greater in an order of He, Ar, Xe.

Namely, the above result is thought to suggest that contribution to nitrogen dissociation by the noble gas (electron temperature) is significant to the etching efficiency (rate) to a greater extent than influence of physical etching by noble gas ions.

Therefore, high density plasma (microwave plasma, ICP and the like), which efficiently dissociates nitrogen, is preferably used as plasma in an etching apparatus (plasma etching apparatus) where the process gas is dissociated. An example of a substrate process apparatus that is used for fabricating the light emitting device and includes such a plasma apparatus is described in Example 3 or later.

In addition, the fabrication method according to an example of the present invention is not limited to the above example, but may be altered or modified as described below.

### < Example 2 >

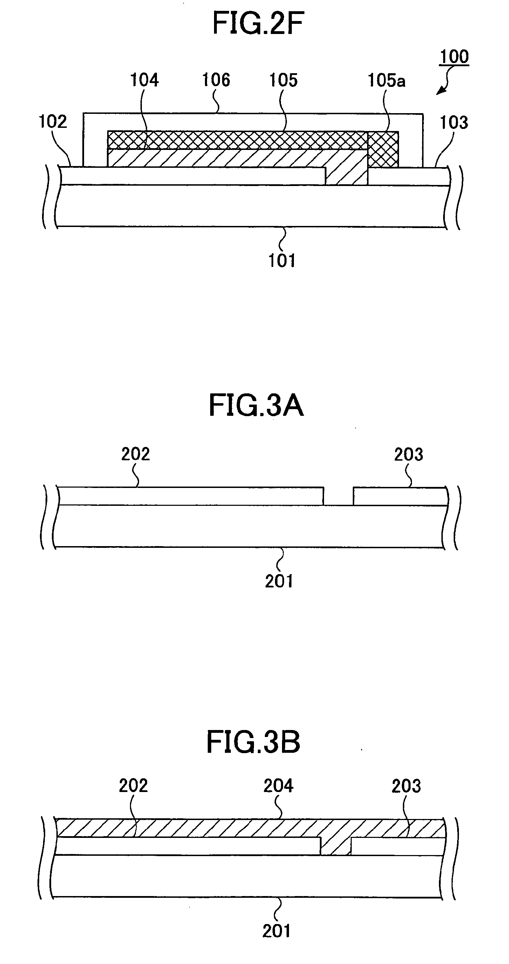

FIGS. 3A through 3G sequentially illustrate Example 2 of a fabrication method of a light emitting device according to the present invention. In the drawings, the same reference marks are given to the portions described above, and explanation may be omitted.

Steps shown in FIGS. 3A through 3D correspond to the steps shown in FIGS. 2A through 2D in Example 1. A substrate 201, a positive electrode 202, a leading wire 203, an organic layer 204, and a negative electrode 205 correspond to the substrate 101, the positive electrode 102, the leading wire 103, the organic layer 104, and the negative electrode 105 in Example 1, respectively, and can be formed of the corresponding materials in the same manner described in Example 1.

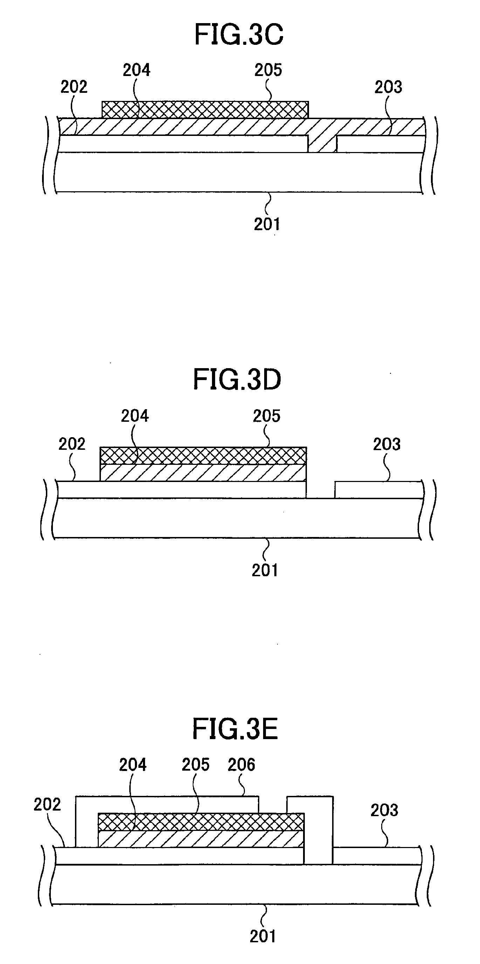

In the case of this example, the shape of the negative electrode 205 is different from the corresponding negative electrode 105 of Example 1 and the negative electrode 205 has a smaller area. Therefore, the organic layer 204 between the positive electrode 202 and the leading wire 203 is removed by etching, in the step shown in FIG. 3D.

Next, in a step shown in FIG. 3E, an insulating protection film 206 formed of, for example, silicon nitride (SiN) is formed on the substrate 201 by the CVD method using a patterning mask, so that the protection film 206 covers part of the positive electrode 202, the organic layer 204, and the negative electrode 205. In addition, the protection film 206 is formed to have an opening through which part of the negative electrode 205 is exposed.

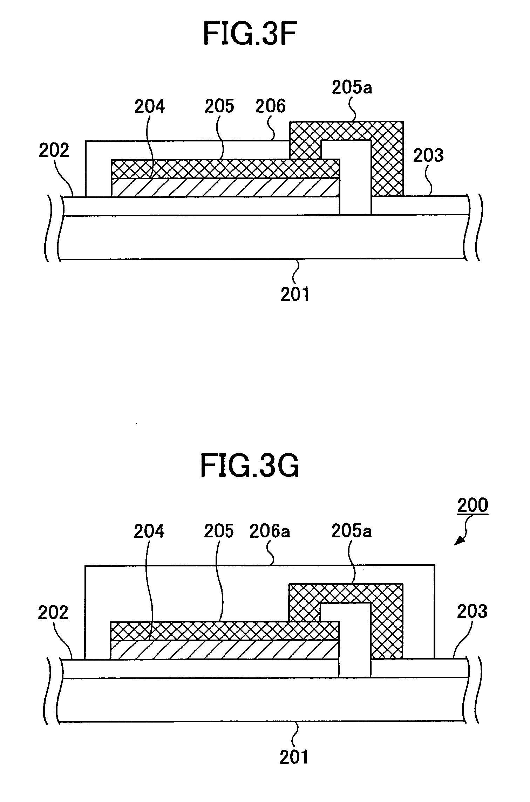

Next, a connection line 205a that electrically connects the negative electrode 205 and the leading wire 203 via the opening is formed into a pattern by, for example, the sputtering method using a patterning mask, in a step shown in FIG. 3F.

In addition, an insulating protection film 206a formed of, for example, silicon nitride (SiN) is formed in order to cover the connection line 205a and part of the leading wire 203 on the substrate 201 by the CVD method using a patterning mask.

In such a manner, a light emitting device 200 configured with the organic layer 204 formed between the positive electrode 202 and the negative electrode 205 can be formed. As previously described, the substrate 201, the positive electrode 202, the leading wire 203, the organic layer 204, and the negative electrode 205 in this example correspond to the substrate 101, the positive electrode 102, the leading wire 103, the organic layer 104, and the negative electrode 105 in Example 1, respectively, and the similar effect is apparently demonstrated even by Example 2.

In the case of Example 2, the protection film 206 formed of, for example, a highly insulating silicon nitride is characteristically used to insulate the positive electrode 202 and the leading wire 203 (the negative electrode 205). Therefore, the light emitting device 200 provides high insulation between the positive electrode 202 and the negative electrode 205 and is highly reliable, compared to Example 1 where the organic layer is used to insulate the positive electrode 102 and the leading wire 103.

### < Example 3 >

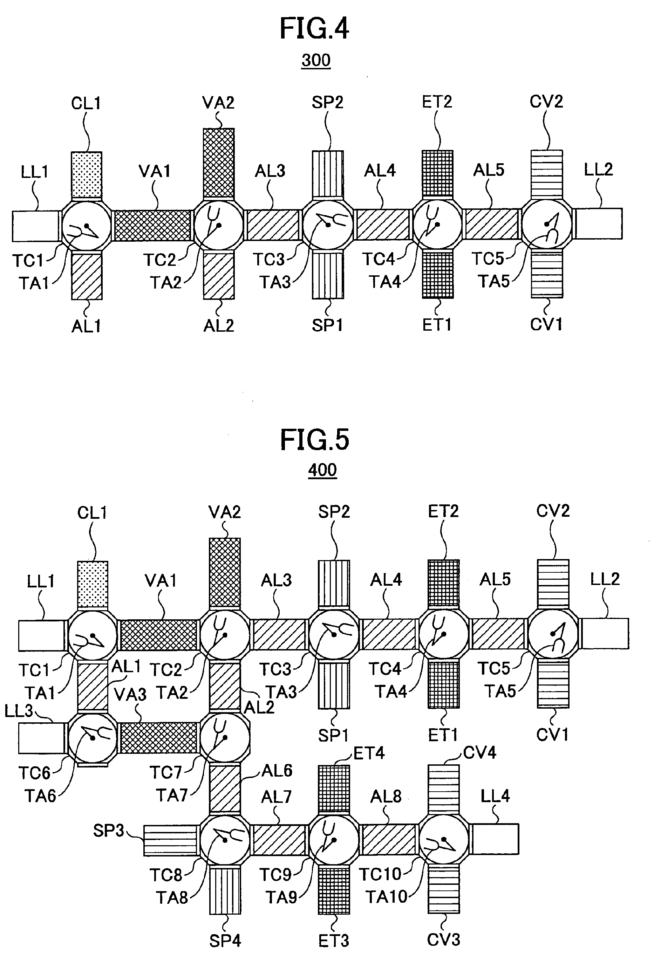

Referring to FIG. 4, an example of a substrate process apparatus that fabricates the light emitting device 100 described in Example 1 is explained.

FIG. 4 is a plan view schematically illustrating an example of a substrate process apparatus 300 that fabricates the light emitting device 100.

Referring to FIG. 4, the substrate process apparatus 300 is configured to connect a process chamber, a deposition apparatus, an etching apparatus, or the like to any one of transfer chambers TC1, TC2, TC3, TC4, TC5 to which a substrate to be processed is transferred. The transfer chambers TC1, TC2, TC3, TC4, TC5 each have four connection surfaces to which the process chamber, the deposition apparatus, the etching apparatus, or the like are connected. In addition, the transfer chambers TC1, TC2, TC3, TC4, TC5 are configured to include inside transfer units (transfer arms) TA1, TA2, TA3, TA4, TA5, respectively.

For example, a pretreatment chamber CL1 where pretreatment (cleaning and the like) is carried out for the substrate to be processed, alignment processing chambers AL1, AL2, AL3, AL4, AL5 where the substrate or a mask to be attached on the substrate is aligned (positioned), deposition apparatuses (organic layer forming apparatuses) VA1, VA2 where the organic layer 104 is formed by the evaporation method (or the step shown in FIG. 2B is carried out), deposition apparatuses (electrode forming apparatuses) SP1, SP2 where the negative electrode 105 is formed by the sputtering method (or the step shown in FIG. 2C is carried out) and the connection line 105a is formed (or the step shown in FIG. 2E is carried out), etching apparatuses ET1, ET2 where the organic layer 104 is etched (or the step shown in FIG. 2D is carried out), deposition apparatuses (protection film forming apparatuses) CV1, CV2 where the protection film 106 is formed (or the step shown in FIG. 2F is carried out), and load lock chambers LL1, LL2 are connected to either one of the transfer chambers TC1, TC2, TC3, TC4, TC5.

The load lock chamber LL1, the pretreatment chamber CL1, the alignment processing chamber AL1, and the deposition apparatus VA1 are connected to the corresponding four connection surfaces of the transfer chamber TC1. The deposition apparatuses VA1, VA2, and the alignment processing chambers AL2, AL3 are connected to the corresponding four connection surfaces of the transfer chamber TC2. The alignment processing chambers AL3, AL4, and the deposition apparatuses SP1, SP2 are connected to the corresponding four connection surfaces of the transfer chamber TC3. The alignment processing chambers AL4, AL5, and the etching apparatuses ET1, ET2 are connected to the corresponding four connection surfaces of the transfer chamber TC4. The alignment processing chamber AL5, the deposition apparatuses CV1, CV2, and the load lock chamber LL2 are connected to the corresponding four connection surfaces of the transfer chamber TC5.

Namely, the deposition apparatus VA1 is connected to the transfer chambers TC1, TC2. The alignment processing chamber AL3 is connected to the transfer chambers TC2, TC3. The alignment processing chamber AL4 is connected to the transfer chambers TC3, TC4. The alignment processing chamber AL5 is connected to the transfer chambers TC4, TC5.

In addition, the pretreatment chamber CL1, the alignment processing chambers AL1, AL2, AL3, AL4, AL5, the deposition apparatuses VA1, VA2, the deposition apparatuses SP1, SP2, the etching apparatuses ET1, ET2, the deposition apparatuses CV1, CV2, and the load lock chambers LL1, LL2 each are connected to an evacuation unit (not shown) such as a vacuum pump and maintained inside at reduced pressures, when necessary.

Next, procedures for fabricating the light emitting device 100 described as Example 1 by use of the substrate process apparatus 300 are explained.

First, the substrate to be processed, which corresponds to the substrate 101 on which the positive electrode 102 and the leading wire 103 are formed as shown in FIG. 2A, is introduced into the substrate process apparatus 300 through the load lock chamber LL1. The substrate introduced into the load lock chamber LL1 is transferred by the transfer unit TA1 to the pretreatment chamber CL1, where the substrate undergoes the pretreatment (cleaning and the like).

Next, the substrate to be processed is transferred by the transfer unit TA1 to the deposition apparatus VA1, and the organic layer 104 of the light emitting device 100 is formed by the evaporation method in the deposition apparatus VA1 (or the step shown in FIG. 2B is carried out). In addition, the organic layer 104 may be multiple organic layers formed on the substrate by use of the deposition apparatus VA2, when necessary.

Next, the substrate on which the organic layer 104 has been formed is transferred by the transfer unit TA2 to the alignment processing apparatus AL2 or AL3, and transferred by the transfer unit TA3 to either one of the deposition chambers SP1, SP2 after the mask is attached on the substrate.

In either one of the deposition apparatuses SP1, SP2, the negative electrode 105 is formed by the sputtering method (or the step shown in FIG. 2C is carried out). The substrate on which the negative electrode 105 has been formed is transferred by the transfer units TA3, TA4 to either one of the etching apparatuses ET1, ET2 after the mask is removed in the alignment processing chamber AL3 or AL4.

In either one of the etching apparatuses ET1, ET2, the organic layer 104 is etched with the negative electrode 105 as the mask (or the step shown in FIG. 2D is carried out) . After the organic layer 104 is patterned, another mask is attached on the substrate in the alignment processing chamber AL3 or AL4, and the substrate is transferred by the transfer units TA3, TA4 to either one of the deposition apparatuses SP1, SP2 again, where the connection line 105a is formed (or the step shown in FIG. 2E is carried out).

Next, after the mask is removed from the substrate in the alignment processing chamber AL3 or AL4, the substrate is transferred by the transfer units TA3, TA4, TA5 to either one of the deposition apparatuses CV1, CV2.

In either one of the deposition apparatuses CV1, CV2, the protection film 106 is formed by the CVD method (or the step shown in FIG. 2F is carried out). In such a manner, the light emitting device 100 of Example 1 is formed, and transferred out from the substrate process apparatus 300 through the load lock chamber LL2.

In the substrate process apparatus 300, the light emitting apparatus 100 can be formed in the immediate consecutive steps. In addition, the substrate process apparatus 300 has the plural transfer chambers and is configured so that the organic layer forming apparatuses, the electrode forming apparatuses, and the etching apparatuses are connected to the different transfer chambers. Namely, the substrate process apparatus 300 according to this example can have the organic layer forming apparatuses, the electrode forming apparatuses, and the etching apparatuses, which provides efficient substrate processing.

In addition, the substrate process apparatus 300 may be modified to be a substrate process apparatus 400 as shown in the following.

FIG. 5 illustrates the substrate process apparatus 400, which is a modification example of the substrate process apparatus 300. The same reference marks are given to the portions described above, and explanation is omitted.

The substrate process apparatus 400 further includes transfer chambers TC6 through TC10, and transfer units TA6 through TA10 that are arranged in the corresponding transfer chambers TC6 through TC10.

In addition, the substrate process apparatus 400 further includes the alignment processing chambers AL6 through AL8 that are connected to any one of the transfer chambers TC6 through TC10, the load lock chambers LL3, LL4, which correspond to the load lock chambers LL1, LL2, a deposition apparatus VA3, which correspond to the deposition apparatus VA1, deposition apparatuses SP3, SP4, which correspond to the deposition apparatuses SP1, SP2, etching apparatuses ET3, ET4, which correspond to the etching apparatuses ET1, ET2, and deposition apparatuses CV3, CV4, which correspond to the deposition apparatuses CV1, CV2. Moreover, the transfer chamber TC6 is connected to the alignment processing chamber AL1, and the transfer chamber TC7 is connected to the alignment processing chamber AL2.

As stated, the etching apparatuses, the deposition apparatuses, the alignment apparatuses, the transfer chambers and the like to be connected may be combined in various ways, when appropriate. In addition, the number of those apparatuses and chambers may be increased or decreased, and the substrate process apparatus may be arbitrarily configured so that improved fabrication efficiency is obtained.

### < Example 4 >

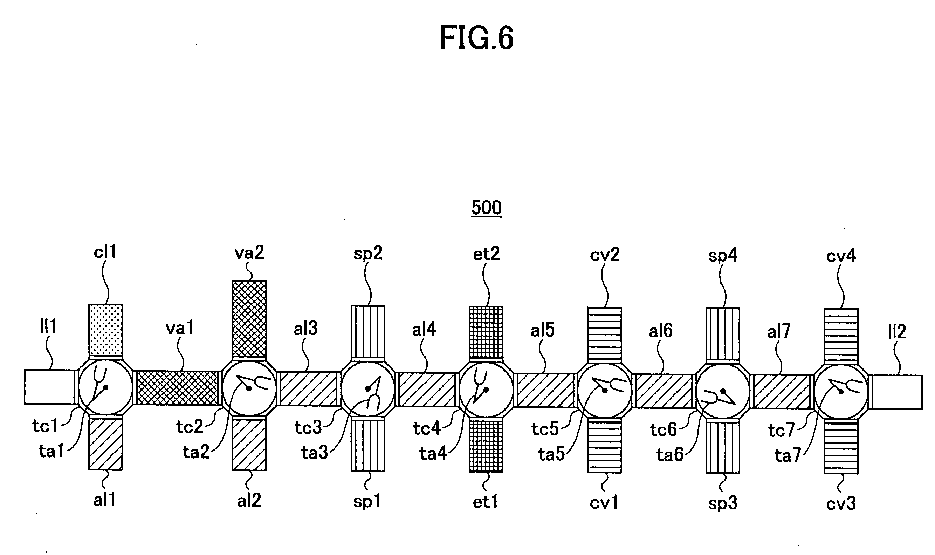

Next, referring to FIG. 6, an example of a substrate process apparatus that fabricates the light emitting device 200 of Example 2 is explained.

FIG. 6 is a plan view schematically illustrating an example of a substrate process apparatus 500 that fabricates the light emitting device.

Referring to FIG. 6, the substrate process apparatus 500 is configured so that the process chambers, the deposition apparatuses, the etching apparatuses and the like are connected to any one of the transfer chambers tc1, tc2, tc3, tc4, tc5, tc6, tc7 through which a substrate to be processed is transferred. The transfer chambers tc1, tc2, tc3, tc4, tc5, tc6, tc7 each have four surfaces to which the process chambers and the deposition apparatuses or the etching apparatuses and the like are connected. In addition, the transfer chambers tc1, tc2, tc3, tc4, tc5, tc6, tc7 are configured to include inside corresponding transfer units (transfer arms) ta1, ta2, ta3, ta4, ta5, ta6, ta7.

For example, a pretreatment chamber cl1 where pretreatment (cleaning and the like) is carried out for the substrate to be processed, alignment processing chambers all, al2, al3, al4, al5 where the substrate or a mask to be attached on the substrate is aligned (positioned), deposition apparatuses (organic layer forming apparatuses) va1, va2 where the organic layer 204 is formed by the evaporation method (or the step shown in FIG. 3B is carried out), deposition apparatuses (electrode forming apparatuses) sp1, sp2 where the negative electrode 205 is formed by the sputtering method (or the step shown in FIG. 3C is carried out), etching apparatuses et1, et2 where the organic layer 204 is etched (or the step shown in FIG. 3D is carried out), deposition apparatuses (protection film forming apparatuses) cv1, cv2 where the protection film 206 is formed (or the step shown in FIG. 3E is carried out), deposition apparatuses (connection line forming apparatuses) sp3, sp4 where the connection line 205a is formed (or the step shown in FIG. 3F is carried out), deposition apparatuses (protection film forming apparatuses) cv3, cv4 where the protection film 206a is formed (or the step shown in FIG. 3G is carried out), and load lock chambers ll1, 112 are connected to any one of the transfer chambers tc1, tc2, tc3, tc4, tc5, tc6, tc7.

The load lock chamber ll1, the pretreatment chamber cl1, the alignment processing chamber all, and the deposition apparatus va1 are connected to the corresponding four connection surfaces of the transfer chamber tc1. The deposition apparatuses va1, va2, and the alignment processing chambers al2, al3 are connected to the corresponding four connection surfaces of the transfer chamber tc2. The alignment processing chambers al3, al4, and the deposition apparatuses sp1, sp2 are connected to the corresponding four connection surfaces of the transfer chamber tc3. The alignment processing chambers al4, al5, and the etching apparatus et1, et2 are connected to the corresponding four connection surfaces of the transfer chamber tc4. The alignment processing chamber al5, al6, and the deposition apparatuses cv1, cv2 are connected to the corresponding four connection surfaces of the transfer chamber tc5. The alignment processing chambers al6, al7, and the deposition apparatuses sp3, sp4 are connected to the corresponding four connection surfaces of the transfer chamber tc6. The alignment processing chamber al7, the deposition apparatuses cv3, cv4, and the load lock chamber ll2 are connected to the corresponding four connection surfaces of the transfer chamber tc7.

Namely, the deposition apparatus va1 is connected to the transfer chambers tc1, tc2. The alignment processing chamber al3 is connected to the transfer chambers tc2, tc3. The alignment processing chamber al4 is connected to the transfer chambers tc3, tc4. The alignment processing chamber al5 is connected to the transfer chambers tc4, tc5. The alignment processing chamber al6 is connected to the transfer chambers tc5, tc6. The alignment processing chamber al7 is connected to the transfer chambers tc6, tc7.

In addition, the pretreatment chamber cl1, the alignment processing chambers all, al2, al3, al4, al5, al6, al7, the deposition apparatuses va1, va2, the deposition apparatuses sp1, sp2, sp3, sp4, the etching apparatuses et1, et2, the deposition apparatuses cv1, cv2, cv3, cv4 and the load lock chambers ll1, ll2 are connected to an evacuation unit (not shown) such as a vacuum pump for evacuating each inside at reduced pressures (vacuum), and maintained inside at reduced pressures when necessary.

Next, procedures for fabricating the light emitting device 200 of Example 2 by use of the substrate process apparatus 500 are explained.

First, the substrate to be processed, which corresponds to the substrate 201 on which the positive electrode 202 and the leading wire 203 are formed as shown in FIG. 3A, is introduced into the substrate process apparatus 500 through the load lock chamber ll1. The substrate introduced into the load lock chamber ll1 is transferred by the transfer unit ta1 to the pretreatment chamber cl1, where the substrate undergoes the pretreatment (cleaning and the like).

Next, the substrate to be processed is transferred by the transfer unit ta1 to the deposition apparatus va1, and the organic layer 204 of the light emitting device 200 is formed by the evaporation method in the deposition apparatus va1 (or the step shown in FIG. 3B is carried out). In addition, the organic layer 204 may be multiple organic layers formed on the substrate by use of the deposition apparatus va2, when necessary.

Next, the substrate to be processed on which the organic layer 204 has been formed is transferred by the transfer unit ta2 to the alignment processing apparatus al2 or al3, where the mask is attached on the substrate, and then transferred by the transfer unit ta3 to either one of the deposition chambers sp1, sp2.

In either one of the deposition apparatuses sp1, sp2, the negative electrode 205 is formed by the sputtering method (or the step shown in FIG. 3C is carried out). The substrate to be processed on which the negative electrode 205 has been formed is transferred by the transfer units ta3, ta4 to either one of the etching apparatuses et1, et2 after the mask is removed in the alignment processing chamber al2 or al3.

In either one of the etching apparatuses et1, et2, the organic layer 204 is etched with the negative electrode 205 as the mask (or the step shown in FIG. 3D is carried out). After the organic layer 204 is patterned, another mask is attached on the substrate in the alignment processing chamber al5, and the substrate is transferred by the transfer units ta5 to either one of the deposition apparatuses cv1, cv2, where the protection film 206 is formed by the CVD method (or the step shown in FIG. 3E is carried out).

Next, after the mask is removed from the substrate to be processed in the alignment processing chamber al5, another mask is attached on the substrate in the alignment processing chamber al6 and transferred by the transfer units ta6 to either one of the deposition apparatuses sp3, sp4.

In either one of the deposition apparatuses sp3, sp4, the connection line 205a is formed by the sputtering method (or the step shown in FIG. 3F is carried out).

Next, after the mask is removed from the substrate to be processed in the alignment processing chamber al6, another mask is attached on the substrate in the alignment processing chamber al7 and transferred by the transfer unit ta7 to either one of the deposition apparatuses cv3, cv4.

In either one of the deposition apparatuses cv3, cv4, the protection film 206a is formed by the CVD method (or the step shown in FIG. 3G is carried out).

In such a manner, the light emitting device 200 of Example 2 is formed, and transferred out from the substrate process apparatus 500 through the load lock chamber ll2.

The substrate process apparatus 500 demonstrates the similar effect as the substrate process apparatus 100 described in Example 3. As stated, the substrate process apparatus 500 may be modified depending on the configurations of the light emitting device.

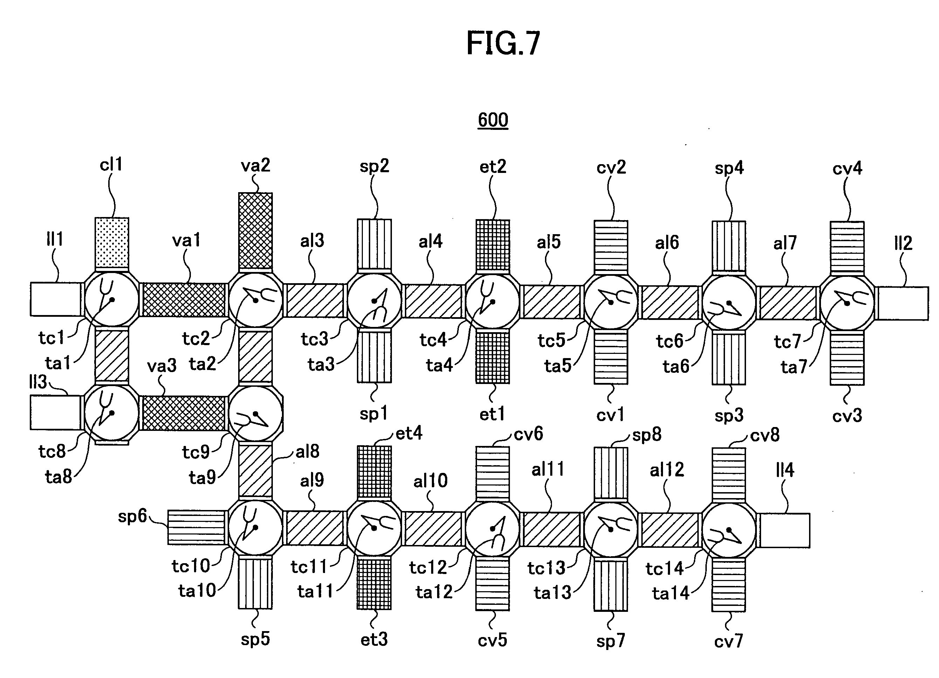

FIG. 7 illustrates a substrate process apparatus 600, which is a modification example of the substrate process apparatus 500. In the drawing, the same reference marks are given to the portion explained above, and the explanation is omitted.

The substrate process apparatus 600 further includes transfer chambers tc8 through tc14, and transfer units ta8 through ta14 that are arranged in the corresponding transfer chambers tc8 through tc14.

In addition, the substrate process apparatus 600 further includes the alignment processing chambers al8, al9, al10, al11, al12 that are connected any one of transfer chambers tc8 through tc14, the load lock chambers ll3, ll4, which correspond to the load lock chambers ll1, ll2, a deposition apparatus va3, which corresponds to the deposition apparatus va1, deposition apparatuses sp5, sp6, sp7, sp8, which correspond to the deposition apparatuses sp1, sp2, sp3, sp4, etching apparatuses et3, et4, which correspond to the etching apparatuses et1, et2, and deposition apparatuses cv5, cv6, cv7, cv8, which correspond to the deposition apparatuses cv1, cv2, cv3, cv4. Moreover, the transfer chamber tc8 is connected to the alignment processing chamber all, and the transfer chamber tc9 is connected to the alignment processing chamber al2.

As stated, the etching apparatuses, the deposition apparatuses, the alignment apparatuses, the transfer chambers and the like to be connected may be combined in various ways, when necessary, even when the light emitting device 200 is formed. In addition, the number of those apparatuses and chambers may be increased or decreased, and the substrate process apparatus may be arbitrarily configured so that improved fabrication efficiency is obtained.

### < Example 5 >

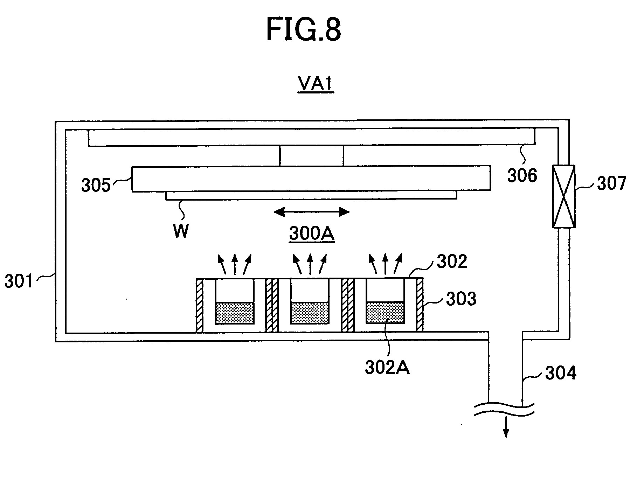

FIG. 8 schematically illustrates an example of a deposition apparatus (organic layer forming apparatus) VA1 for use in the substrate process apparatus 300. The deposition apparatuses VA2, VA3, va1, va2, va3 also have the similar configuration as the deposition apparatus VA1.

Referring to FIG. 8, the deposition apparatus VA1 has a process vessel 301 that defines an inner space 300A inside the process vessel 301. The deposition apparatus VA1 is configured so that plural evaporation sources 302 and one substrate holding pedestal 305 that opposes the plural evaporation sources 302 are arranged in the inner space 300A. The inner space 300A may be evacuated by an evacuation unit (not shown) such as an evacuation pump through an evacuation line 304 and maintained at a predetermined reduced pressure.

The evaporation sources 302 are provided with heaters 303 that heat source materials 302A held inside the evaporation sources 302 in order to vaporize or sublimate the source materials 302A into gaseous source materials. The gaseous source materials are deposited on a substrate W (e.g., the substrate 101 on which the positive electrode 102 and the leading wire 103 are formed) held on the substrate holding pedestal 305, so that the organic layer 104 is formed.

The substrate holding pedestal 305 is configured to be movable along a transfer rail 306 that is installed on a ceiling surface of the process vessel 301 and opposes the evaporation sources 302. Namely, plural layers of the organic layer 104 can be formed because the different gaseous source materials from the plural evaporation sources 302 are sequentially deposited on the substrate to be processed.

In addition, the substrate W to be processed can be transferred into or out from the inner space 300A by opening a gate valve 307 provided at a side to which the transfer chamber is connected in the process vessel 301.

A step, for example, corresponding to the step shown in FIG. 2B described in Example 1 can be carried out by using the deposition apparatus VA1.

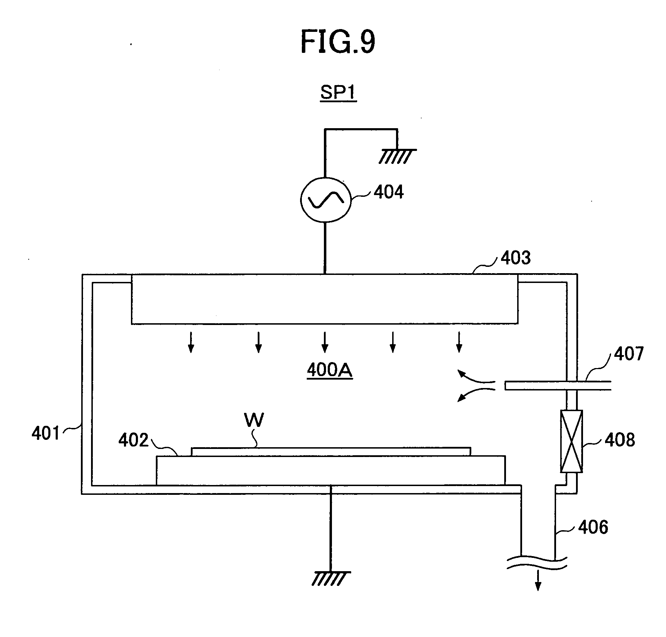

FIG. 9 schematically illustrates an example of the deposition apparatus (electrode forming apparatus) SP1 for use in the substrate process apparatus 300. The deposition apparatuses SP2, SP3, SP4, sp1, sp2, sp3, sp4, sp5, sp6, sp7, sp8 have the similar configuration as the deposition apparatus SP1.

Referring to FIG. 9, the deposition apparatus SP1 has a process vessel 401 that defines an inner space 400A inside of the process vessel 401. The deposition apparatus SP1 is configured so that a target (negative electrode) 403 and a substrate holding pedestal (positive electrode) 402 are arranged in the inner space 400A. The inner space 400A may be evacuated by an evacuation unit (not shown) such as an evacuation pump through an evacuation line 406 and maintained at a predetermined reduced pressure.

A gas such as Ar for plasma excitation is supplied to the inner space 400A from a gas supplying portion 407. Plasma is excited in the inner space 400A by applying radio frequency power to the target 403 from a radio frequency power source 404, and thus Ar ions are produced. The target 403 is sputtered by the Ar ions so produced and the negative electrode 105 is formed on the substrate W to be processed (e.g., the substrate 101 on which the positive electrode 102, the leading wire 103, and the organic layer 104 are formed) held on the substrate holding pedestal 402.

In addition, the substrate W to be processed can be transferred into or out from the inner space 400A by opening a gate valve 408 provided at a side to which the transfer chamber is connected in the process vessel 401.

A step, for example, corresponding to the step shown in FIG. 2C described in Example 1 can be carried out by using the deposition apparatus SP1.

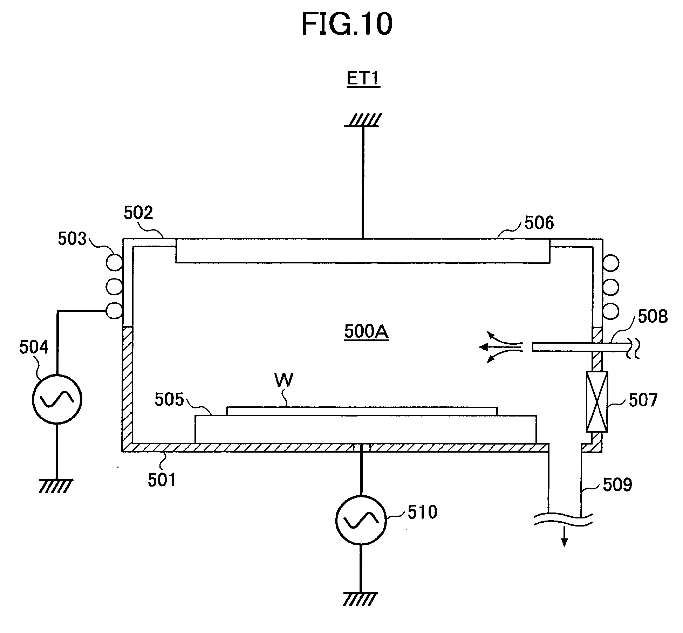

FIG. 10 schematically illustrates an example of the etching apparatus ET1 for use in the substrate process apparatus 300. The etching apparatuses ET2, ET3, ET4, et1, et2, et3, et4 have the similar configuration as the etching apparatus ET1.

Referring to FIG. 10, the etching apparatus ET1 has process vessels 501, 502 that are combined to define an inner space 500A inside the etching apparatus ET1. The etching apparatus ET1 is configured so that a ground plate 506 and a substrate holding pedestal 505 are arranged in order to oppose each other in the inner space 500A. The inner space 500A may be evacuated by an evacuation unit (not shown) such as an evacuation pump through an evacuation line 509 and maintained at a predetermined reduced pressure.

In addition, the process vessel 501 is made of, for example, metal, and the process vessel 502 is made of a dielectric material. A coil 503 to which radio frequency power is applied from a radio frequency power source 504 is arranged outside the process vessel 502. In addition, the radio frequency power is applied to the substrate holding pedestal 505.

A process gas such as N₂/Ar for etching is supplied to the inner space 500A from a gas supplying portion 508. The process gas is plasma-excited by applying the radio frequency power to the coil 503. Such plasma may be called high density plasma (ICP). For example, the step shown in FIG. 2D in Example 1 can be carried out by the process gas dissolved by the high density plasma (or the organic layer 104 is etched with the negative electrode 105 as the mask).

In addition, the substrate W to be processed can be transferred into or out from the inner space 500A by opening a gate valve 507 provided at a side to which the transfer chamber is connected in the process vessel 501.

As explained above, when N₂ is used as the process gas, efficiently etching the organic layer 104 can be carried out by plasma-etching by use of the negative electrode 105 having Ag as the primary constituent as the mask, while damage on the negative electrode 105 is suppressed.

As the plasma that dissolves the process gas in the etching apparatus, the high density plasma that can highly efficiently dissolve nitrogen is preferably used. However, the high density plasma is not limited to ICP. For example, microwave plasma may be used in order to obtain the same results.

Although preferred examples of the present invention have been explained, the present invention is not limited to a particular example described above. The present invention may be variously altered or modified within the scope of the accompanying Claims.

### INDUSTRIAL APPLICABILITY

According to examples of the present invention, a high quality light emitting device, a fabrication method that fabricates the light emitting device, and a substrate process apparatus that can fabricate the light emitting device can be provided.

This international patent application is based on Japanese Priority Application No. 2006-36917, filed on February 14, 2006, with the Japanese Patent Office, the entire contents of which are hereby incorporated herein by reference.

## Claims

1. A fabrication method of a light emitting device configured with an organic layer including a light emitting layer, the organic layer being formed between a first electrode and a second electrode, the method comprising:
an organic layer forming step wherein the organic layer is formed on the first electrode formed on a substrate;
an electrode forming step wherein the second electrode is formed on the organic layer; and
an etching step wherein the organic layer is etched.

2. The fabrication method of claim 1, wherein the organic layer is etched with the second electrode as a mask in the etching step.

3. The fabrication method of claim 2, wherein the second electrode is deposited into a predetermined shape in the electrode forming step.

4. The fabrication method of claim 1, wherein the organic layer is etched by exciting a process gas including N₂ into plasma in the etching step.

5. The fabrication method of claim 4, wherein the process gas includes a noble gas.

6. The fabrication method of claim 4, wherein the second electrode includes Ag as a primary constituent.

7. A substrate process apparatus wherein a light emitting device configured with an organic layer including a light emitting layer, the organic layer being formed between a first electrode and a second electrode, is formed on a substrate to be processed, the substrate process apparatus comprising:
an organic layer forming apparatus wherein the organic layer is formed on the first electrode formed on the substrate to be processed;
an electrode forming apparatus wherein the second electrode is formed on the organic layer; and
an etching apparatus wherein the organic layer is etched.

8. The substrate process apparatus of claim 7, further comprising:
a first transfer unit that transfers the substrate to be processed from the organic forming apparatus to the electrode forming apparatus; and
a second transfer unit that transfers the substrate to be processed from the electrode forming apparatus to the etching apparatus.

9. The substrate process apparatus of claim 8, wherein the organic layer forming apparatus, the electrode forming apparatus, and the etching apparatus are connected to a transfer chamber having either one of the first transfer unit and the second transfer unit.

10. The substrate process apparatus of claim 9, further comprising plural of the transfer chambers.

11. The substrate process apparatus of claim 10, wherein the organic layer forming apparatus, the electrode forming apparatus, and the etching apparatus are connected to the different transfer chambers.

12. The substrate process apparatus of claim 7, wherein the substrate process apparatus is configured so that forming the organic layer, forming the second electrode on the organic layer, and etching the organic layer may be consecutively performed.

13. The substrate process apparatus of claim 7, wherein the organic layer is etched with the second electrode as a mask in the etching apparatus.

14. The substrate process apparatus of claim 7, wherein the etching apparatus etches the organic layer by exciting a process gas including N₂ into plasma.

15. The substrate process apparatus of claim 14, wherein the etching apparatus excites the process gas with high density plasma.

16. The substrate process apparatus of claim 15, wherein the process gas includes a noble gas.

17. The substrate process apparatus of claim 14, wherein the electrode forming apparatus forms the second electrode including Ag as a primary constituent on the organic layer.

18. The substrate process apparatus of claim 7, further comprising a protection film forming apparatus wherein a protection film is formed in order to cover the second electrode.

19. A light emitting device configured with an organic layer including a light emitting layer, the organic layer being formed between a first electrode and a second electrode, the light emitting device comprising:
the second electrode and the organic layer being patterned to have substantially the same top view shape.

20. The light emitting device of claim 19, wherein a surface of metal constituting the second electrode is nitrided.
